# FASCICULE DE BREVET EUROPEEN

(11) **EP 1 012 881 B1**
(45) Date de publication et mention de la délivrance du brevet: **11.09.2002**
(21) Numéro de dépôt: 97924188.2
(22) Date de dépôt: 13.06.1997
(51) Int. Cl.: H01L 27/02

(54) **PROCEDE DE FABRICATION D'UN CIRCUIT INTEGRE ET CIRCUIT INTEGRE REALISE SELON CE PROCEDE**
HERSTELLUNGSVERFAHREN FÜR EINEN INTEGRIERTEN SCHALTKREIS UND DER DAMIT HERGETELLTE INTEGRIERTE SCHALTKREIS
METHOD FOR MAKING AN INTEGRATED CIRCUIT AND INTEGRATED CIRCUIT PRODUCED BY SAID METHOD

(43) Date de publication de la demande: 28.06.2000
(73) Titulaire: Kowalski, Tomasz, 01-930 Varsovie (PL)
(72) Inventeur: KOWALSKI, Tomasz, PL-01-930 Varsovie (PL)
(74) Mandataire: Marchand, André
(86) Numéro de dépôt international: IB9700695
(87) Numéro de publication internationale: WO98057373

(56) Documents cités:
- US-A- 5 452 355
- PATENT ABSTRACTS OF JAPAN vol. 010, no. 343 (E-456), 19 novembre 1986 & JP 61 147551 A (NEC CORP), 5 juillet 1986,

## Description

La présente invention concerne un procédé de fabrication d'un circuit intégré et un circuit intégré réalisé selon ce procédé.

L'objectif de la présente invention est de préserver l'intégrité des circuits intégrés vis à vis de personnes qui voudraient en découvrir la structure et le fonctionnement.

De façon générale, lorsque l'on observe un circuit intégré au moyen d'un microscope optique ou électronique (on pourra également se munir d'une photographie de circuit intégré faite avec un fort grossissement), on distingue tout d'abord à la surface du circuit des zones de silicium de grande densité, ou zones actives, comprenant des éléments actifs et passifs comme des transistors, des résistances, des capacités électriques... Entre ces zones actives, on distingue des zones de moins grande densité comportant des pistes conductrices reliant les zones actives entre elles. Si l'on observe de plus près la surface des pistes conductrices, on distingue en certains points des altérations qui peuvent être des bosses ou des creux. De telles altérations correspondent à des orifices d'interconnexion électrique reliant les pistes conductrices de la surface à des pistes conductrices présentes dans la profondeur du circuit intégré, ou pistes enterrées. Ces orifices de faible diamètre (classiquement de l'ordre de 1 micromètre) traversent une couche isolante pour atteindre les piste enterrées, lesquelles participent, avec les pistes de surface, à l'interconnexion des zones actives du circuit intégré.

Selon l'invention, on propose de réaliser, dans un circuit intégré, des orifices d'interconnexion factices, c'est-à-dire des orifices d'interconnexion ne reliant pas électriquement des pistes conductrices de niveaux différents.

L'idée de l'invention est d'empêcher, ou du moins rendre inextricable, les opérations dites "d'ingénierie inverse" qui permettent d'analyser les circuits intégrés et d'en découvrir la structure et les secrets de fonctionnement.

Une opération d'ingénierie inverse portant sur un circuit intégré comprend en effet les étapes suivantes :
i) une étape de repérage visuel des liaisons électriques entre les zones actives du circuit intégré,
ii) une étape de reconstitution du schéma des interconnexions des zones actives,
iii) une étape d'analyse du fonctionnement électrique du circuit intégré, consistant à observer les divers signaux électriques circulant entre les zones actives, par exemple au moyen d'un microscope à balayage électronique,
iv) une étape de reconstitution de la structure et du fonctionnement des zones actives du circuit intégré au moyen d'un logiciel de simulation électrique et à partir des résultats des étapes ii) et iii) précédentes.

L'étape initiale i) de repérage des liaisons électriques entre les zones actives, dite de recherche des équipotentielles, est une étape essentielle du procédé d'ingénierie inverse et comprend nécessairement des étapes d'analyse de la topographie (ou agencement) des pistes conductrices de surface, d'analyse de la topographie des pistes enterrées, et d'analyse des interconnexions entre ces pistes. Ces étapes sont essentiellement basées sur l'observation visuelle. En général, on repère tout d'abord la topographie des pistes conductrices du niveau visible et, grâce aux altérations décrites plus haut, on repère la répartition des orifices d'interconnexion. Par une abrasion chimique de la surface du circuit intégré, on fait ensuite apparaître les pistes enterrées et on détermine leurs connexions avec les pistes du niveau supérieur. Une fois connus la topographie des divers niveaux de pistes conductrices et les interconnexions entre ces niveaux, il est aisé d'en déduire les liaisons électriques existant entre les zones fonctionnelles.

La présente invention propose donc de rendre difficile voire rédhibitoire la réalisation de cette première étape du procédé d'ingénierie inverse, par la prévision de faux orifices d'interconnexion ayant un aspect authentique et induisant en erreur la personne procédant à l'analyse d'un circuit intégré selon l'invention.

Pour résoudre ce problème, la demande de brevet japonais JP-A-61 147 551 propose de créer des orifices d'interconnexion factices ne traversant pas entièrement la couche isolante qui sépare deux niveaux de pistes conductrices.

Toutefois, une abrasion chimique de la couche isolante selon un plan passant en dessous du fond des orifices d'interconnexion factices peut permettre de différencier les orifices d'interconnexion factices des vrais orifices d'interconnexion.

Ainsi, l'invention concerne un procédé de fabrication d'un circuit intégré, comprenant une étape de fabrication d'au moins un premier niveau de pistes conductrices, une étape de fabrication d'une couche isolante couvrant le premier niveau de pistes conductrices, une étape de fabrication dans la couche isolante d'une pluralité d'orifices d'interconnexion traversant entièrement la couche isolante, et une étape de fabrication d'au moins un deuxième niveau de pistes conductrices susceptibles d'être connectées électriquement aux pistes du premier niveau au moyen des orifices d'interconnexion, procédé comprenant une étape de fabrication d'une barrière d'isolement électrique pour l'isolement électrique d'au moins un orifice d'interconnexion.

Selon un mode de réalisation, l'étape de fabrication de la barrière d'isolement électrique comprend une étape de fabrication d'une couche d'un matériau isolant dans l'orifice d'interconnexion.

Selon un mode de réalisation, l'étape de fabrication de la barrière d'isolement électrique comprend une étape de fabrication d'au moins une couche de silicium dopé dans l'orifice d'interconnexion.

Selon un mode de réalisation, l'étape de fabrication de la barrière d'isolement électrique comprend une étape de fabrication, dans une piste conductrice en silicium dopé N ou P, d'une zone de diffusion inverse P ou N formant avec la piste une jonction PN, à l'endroit où débouche l'orifice d'interconnexion.

La présente invention concerne également un circuit intégré comprenant des pistes conductrices réparties sur au moins un premier et un second niveau de profondeur du circuit intégré, et des orifices d'interconnexion présumée de pistes des premier et second niveaux pratiqués dans toute l'épaisseur d'une couche isolante séparant les deux niveaux de pistes, dans lequel certains orifices d'interconnexion présumée comportent une barrière d'isolement électrique et ne relient pas électriquement des pistes des premier et second niveaux.

Selon un mode de réalisation, le circuit intégré comprend des orifices comportant une couche d'oxyde formant la barrière d'isolement électrique.

Selon un mode de réalisation, le circuit intégré comprend des orifices comportant une jonction silicium de type PN ou NP formant la barrière d'isolement électrique.

Selon un mode de réalisation, le circuit intégré comprend des orifices débouchant sur une jonction silicium de type PN ou NP formant la barrière d'isolement électrique.

Ces caractéristiques, ainsi que d'autres, et les avantages de la présente invention seront exposés en détail dans la description suivante d'un procédé de fabrication d'un circuit intégré selon l'invention et de divers exemples d'orifices d'interconnexion selon l'invention, en relation avec les figures jointes parmi lesquelles :
- les figures 1A et 1B représentent de façon partielle deux niveaux de pistes conductrices d'un circuit intégré,
- la figure 2 est une vue en coupe partielle d'un circuit intégré et représente un mode de réalisation classique d'un orifice d'interconnexion factice,
- la figure 3 représente un mode de réalisation d'un orifice d'interconnexion selon l'invention,
- la figure 4 représente une variante de l'orifice d'interconnexion de la figure 3,
- la figure 5 représente un autre mode de réalisation d'un orifice d'interconnexion selon l'invention, et
- les figures 6A à 6F illustrent des étapes d'un procédé de fabrication d'un circuit intégré selon l'invention.

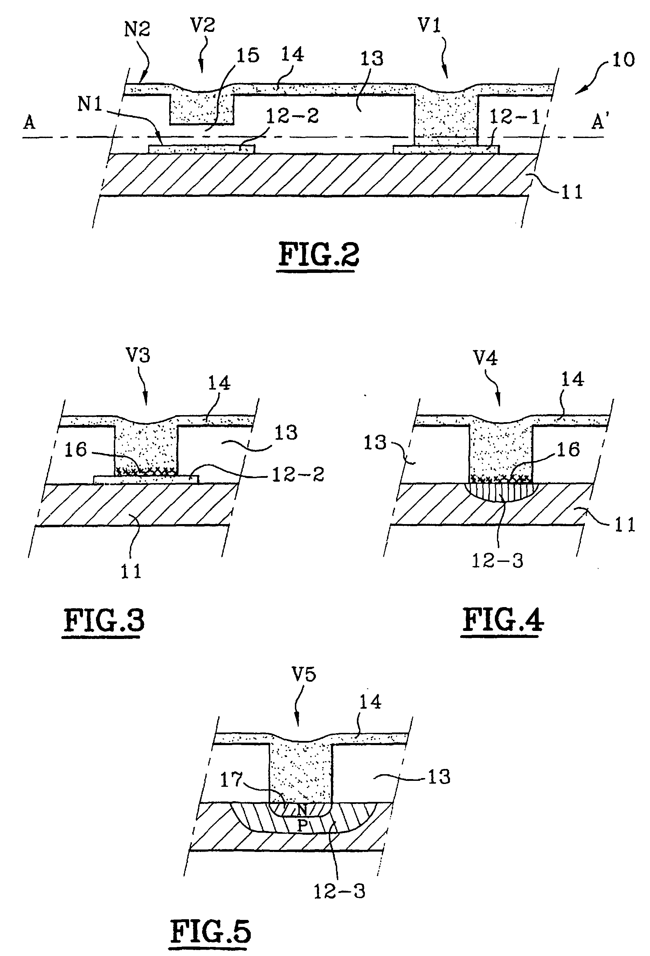

Sur les diverses vues en coupe des figures 2 à 6F, les épaisseurs relatives des couches d'un circuit intégré ne sont pas à l'échelle mais ont été tracées arbitrairement pour améliorer la lisibilité des figures.

Comme on l'a indiqué plus haut, la présente invention propose de rendre difficile voire rédhibitoire la réalisation de la première étape du procédé d'ingénierie inverse concernant les circuits intégrés (repérage visuel des interconnexions) par la prévision de faux orifices d'interconnexion ayant un aspect authentique et induisant en erreur la personne procédant à l'analyse du circuit.

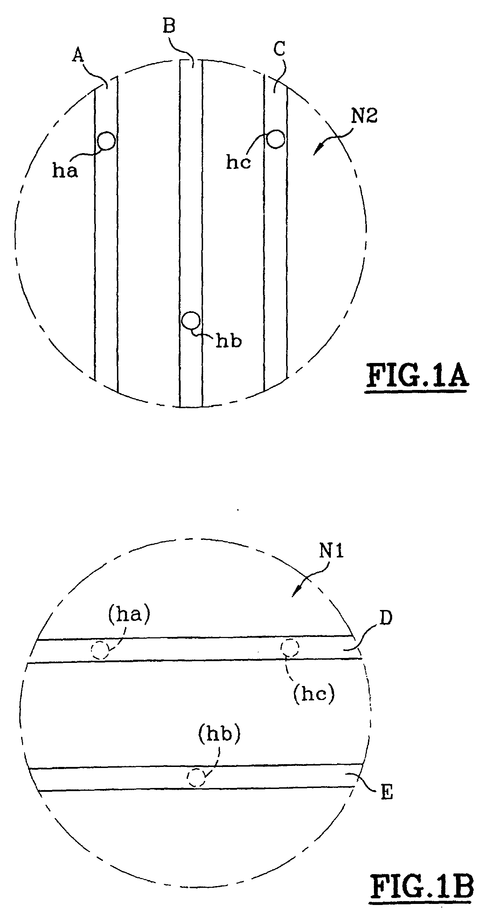

Pour fixer tout d'abord les idées sur les avantages offerts par l'invention, la figure 1A représente une vue de dessus partielle d'un niveau N2 d'un circuit intégré, par exemple le niveau de surface, et la figure 1B représente une vue de dessus partielle d'un niveau inférieur N1 tel qu'il peut apparaître après une destruction chimique du niveau N2 et de la couche isolante séparant les deux niveaux. Au niveau N2, on voit trois pistes conductrices A, B, C présentant des altérations ha, hb, hc correspondant à des orifices d'interconnexion présumée avec des pistes du niveau inférieur N1. Au niveau N1, on voit deux pistes conductrices D et E. En principe, la superposition des figures 1A et 1B et la position des altérations ha, hb, hc permettent de déduire sans ambiguïté que les pistes A et C du niveau N2 sont connectées à la piste D du niveau N1 et que la piste B est connectée à la piste E : on a donc trouvé une équipotentielle A-D-C et une équipotentielle B-E.

En réalité, selon l'invention, la superposition des figures 1A et 1B ne confère aucune certitude, étant donné que les altérations ha, hb et hc correspondent peut-être à des orifices d'interconnexion factices.

La figure 2 est une vue partielle en coupe d'un circuit intégré 10 à deux niveaux de pistes conductrices N1, N2 et représente un orifice d'interconnexion "vrai" v1 et un orifice d'interconnexion factice v2 de type classique. On aperçoit sur cette vue partielle deux pistes conductrices 12-1, 12-2 du niveau N1 (en coupe transversale) et une piste conductrice 14 du niveau N2 (en coupe longitudinale). Les pistes 12-1 et 12-2, par exemple en métal ou en polysilicium, reposent sur le substrat 11 du circuit intégré et sont couvertes par une couche isolante 13, par exemple de l'oxyde de silicium SiO2, dans laquelle sont pratiqués les orifices v1 et v2. La piste conductrice 14 repose sur la couche isolante 13 et le matériau qui la constitue, par exemple du métal, s'étend à l'intérieur des orifices v1 et v2. L'orifice v1 est disposé au croisement de la piste 14 et de la piste 12-1 et l'orifice v2 au croisement de la piste 14 et de la piste 12-2. Sur la figure 2, on voit que l'orifice v1 traverse entièrement la couche isolante 13 de sorte que les pistes 14 et 12-1 sont connectées électriquement. Par contre, l'orifice v2 ne traverse pas entièrement la couche isolante 13 ce qui empêche la piste 14 d'être au contact de la piste 12-2..

La figure 3 représente, par une vue en coupe, un mode de réalisation d'un orifice d'interconnexion factice v3 selon l'invention. Ici, l'orifice v3 traverse entièrement la couche isolante 13 mais comporte une barrière d'isolement électrique 16 de faible épaisseur, par exemple une fine barrière d'oxyde d'une épaisseur de 80 angstrôms (soit 10 à 15 couches atomiques d'oxyde), disposée au fond de l'orifice v3 à la surface de la piste conductrice 12-2 (pour fixer les idées, l'épaisseur de la couche isolante 13 est classiquement de l'ordre de 5 micromètres). Comme cela est bien connu de l'homme de l'art, une couche d'oxyde d'une telle épaisseur est suffisante pour empêcher la circulation d'un courant sous une tension pouvant atteindre les 10 V.

L'orifice v3 de la figure 3 présente sur l'orifice v2 de la figure 2 l'avantage de ne pouvoir être distingué d'un orifice "vrai" après abrasion chimique totale ou partielle de la couche isolante 13, car une telle abrasion détruirait la barrière d'isolement 16, compte tenu de sa finesse. Par contre, si l'on se reporte à la figure 2, on voit qu'une abrasion chimique de la couche isolante 13 selon un plan AA' passant par la barrière isolante 15 pourrait peut-être permettre de différencier l'orifice factice v2 de l'orifice "vrai" v1.

Bien entendu, des orifices d'interconnexion factices selon l'invention peuvent être prévus à tous niveaux de profondeur d'un circuit intégré, par exemple entre les niveaux classiques N1 à N4 suivants (indiqués selon un ordre de profondeur décroissante) :
N1 : pistes conductrices en silicium dopé N ou P,
N2 : pistes conductrices en silicium polycristallin (ou polysilicium),
N3 (ou Métal 1) : pistes métalliques enterrées,
N4 (ou Métal 2) : pistes métalliques à la surface du circuit intégré.

Ainsi, comme montré sur la figure 4, un orifice d'interconnexion factice v4 comprenant une barrière d'oxyde 16 peut également déboucher sur une piste inférieure 12-3 en silicium dopé P ou N.

La figure 5 illustre un mode de réalisation d'un orifice factice v5 dans lequel la barrière d'isolement électrique est une jonction PN. Dans cet exemple, l'orifice v5 débouche sur une piste inférieure 12-3 en silicium dopé P. Une zone 17 de diffusion N est créée dans l'épaisseur même de la piste 12-3, à l'endroit où débouche l'orifice v5. La jonction PN ainsi réalisée forme une sorte de diode se trouvant en permanence dans l'état bloqué quand la piste inférieure 12-3 reçoit une tension électrique supérieure au potentiel électrique de la piste supérieure 14. Bien entendu, la piste 12-3 peut être en silicium dopé N et la zone de diffusion 17 en silicium dopé P.

De nombreux autres modes de réalisation de l'invention pourront être mis en oeuvre par l'homme de l'art. Par exemple, sur la figure 5, la jonction PN aurait pu être réalisée par un dépôt, au fond de l'orifice v5, d'une fine couche de silicium, suivi d'un dopage N de cette couche. Egalement, une jonction PN peut être réalisée par dépôt successif, dans l'orifice d'interconnexion, de deux couches de silicium, l'une étant dopée P et l'autre dopée N (ou inversement). Ce mode de réalisation n'est pas seulement réservé aux orifices d'interconnexion débouchant sur des pistes en silicium dopé et peut s'appliquer aux orifices d'interconnexion reliant deux pistes métalliques ou reliant une piste métallique et une piste en polysilicium.

Ainsi, en fonction des différences de potentiel électrique devant être appliqués aux pistes conductrices, on pourra disposer des jonctions PN ou NP, voire des jonctions PNP ou NPN si les potentiels électriques entre pistes conductrices sont susceptibles de s'inverser.

Comme cela apparaîtra clairement à l'homme de l'art, la présente invention peut être mise en oeuvre sans modification substantielle des procédés de fabrication classiques des circuits intégrés, seule une étape intermédiaire de fabrication de la barrière d'isolement électrique dans certains orifices d'interconnexion devant être prévue.

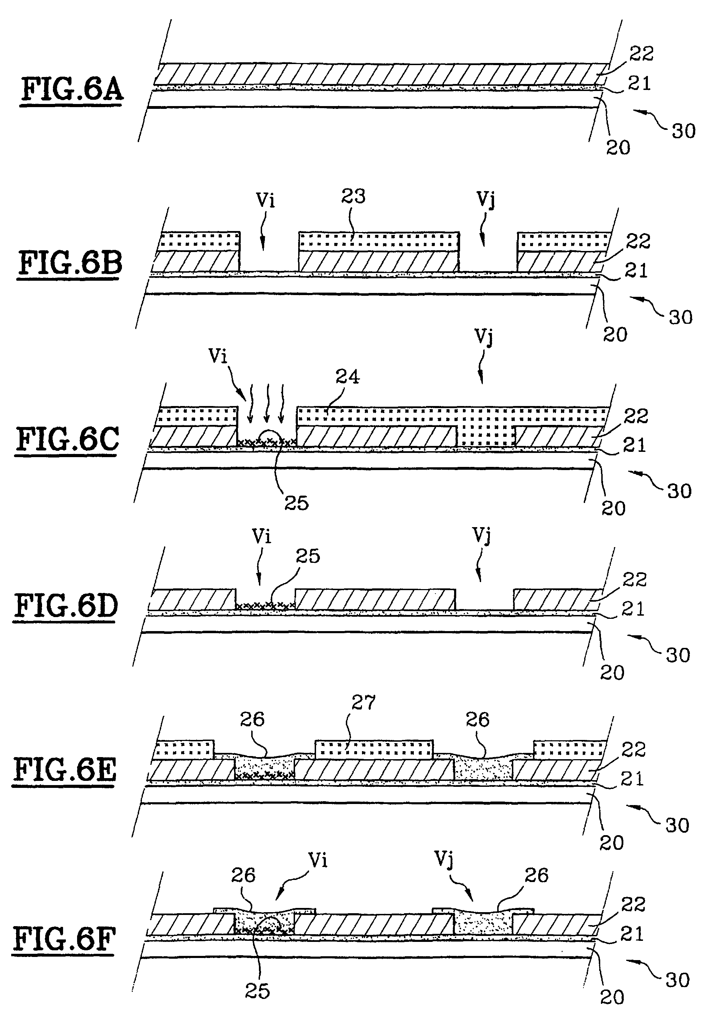

A titre d'exemple, les figures 6A à 6F représentent, parmi les étapes successives de fabrication d'un circuit intégré 30, celles qui caractérisent l'invention.

Au cours d'une étape représentée en figure 6A, on a implanté classiquement à la surface d'une plaquette de silicium 20 des pistes conductrices 21 (une seule piste 21, vue en coupe longitudinale, apparaît sur la figure), et l'on a déposé sur l'ensemble une couche d'oxyde 22.

Au cours d'une étape représentée en figure 6B, on a déposé classiquement un masque de gravure 23 sur le circuit intégré et l'on a fait apparaître des orifices d'interconnexion vi, vj dans la couche d'oxyde 22. Les orifices vj sont destinés à des interconnexions classiques alors que les orifices vi ont été prévus, au stade de la conception du circuit intégré, pour réaliser des interconnexions factices.

Ainsi, dans une étape illustrée en figure 6C, on masque les orifices vj sauf les orifices vi au moyen d'une résine 24, et l'on dépose une fine couche d'oxyde 25 au fond des orifices vi par croissance sèche ou humide. De préférence, la fine couche d'oxyde 25 est d'une épaisseur très faible de l'ordre de quelques dizaines d'angströms pour n'être pas décelable par abrasion chimique, comme indiqué plus haut.

La figure 6D montre l'aspect intermédiaire du circuit intégré 30 une fois le masque 24 dissout. Vu en coupe, le circuit intégré a l'aspect d'un circuit classique à la différence près que les orifices vi (un seul étant représenté sur la figure 6D) sont "bouchés" par la fine couche d'oxyde 25.

Ensuite, dans une étape illustrée en figure 6E, on réalise de façon classique des pistes conductrices 26 par dépôt de métal ou de polysilicium sur l'oxyde 22 au moyen d'un masque approprié 27.

La figure 6F représente l'aspect final du circuit intégré 30 une fois le masque 27 dissout. On voit que les orifices d'interconnexion vi réalisés ont la structure de l'orifice v3 décrit en relation avec la figure 3.

Bien entendu, le procédé qui vient d'être décrit est susceptible de nombreuses variantes et modes de réalisation. Par exemple, si les pistes inférieures 21 sont en silicium dopé N ou P, l'étape de la figure 6C peut être une étape de dopage P ou N de la zone des pistes 21 apparaissant au fond des orifices vi, conformément au mode de réalisation de la figure 5.

Egalement, l'étape de la figure 6C peut comprendre une étape de croissance d'une fine couche de silicium au fond des orifices vi, puis de dopage N de cette couche, puis de croissance d'une deuxième couche de silicium de faible épaisseur, puis de dopage P de la deuxième couche, de manière à réaliser à l'intérieur des orifices une jonction PN ou NP de faible épaisseur.

En définitive, les diverses possibilités pour l'implantation d'une barrière d'isolement électrique ou barrière de conduction dans un orifice d'interconnexion peuvent être résumées comme suit :
- dépôt d'un matériau isolant dans l'orifice, en général un oxyde de silicium,
- croissance thermique d'un isolant (ou toute autre méthode de dépôt) dans l'orifice (possible entre pistes métal 1/métal 2 ou polysilicium/métal 1 ou encore polysilicium/métal 2),
- dopage inverse P ou N de la piste inférieure, dans la zone où débouche l'orifice (possible pour des pistes inférieures dopées N ou P),
- dépôt dans l'orifice d'une jonction PN ou NP ou tout autre moyen permettant de créer une barrière de conduction.

Bien entendu, les étapes décrites plus haut, de création de connexions factices selon l'invention, peuvent être insérées dans n'importe quel procédé classique de fabrication d'un circuit intégré, comprenant d'autres étapes de fabrication, par exemple de fabrication de transistors, de composants actifs ou passifs, qui n'ont pas été décrites et représentées dans un souci de simplicité.

D'autre part, ces étapes peuvent être répétées autant que nécessaire, selon le nombre de niveaux de pistes conductrices (N1, N2, N3, N4, etc.) que comporte le circuit intégré. Egalement, les diverses méthodes proposées plus haut (dépôt d'isolant, création d'une jonction PN, ...) peuvent être combinées.

En pratique, la présente invention peut être mise en oeuvre de façon systématique au stade de la conception d'un circuit intégré moyennant une modification à la portée de l'homme de l'art des outils de conception classiques. En effet, les pistes conductrices d'un circuit intégré, leur agencement sur plusieurs niveaux de profondeur, leur répartition (ou topographie) sur chaque niveau, et les interconnexions entre différents niveaux sont généralement déterminés par des logiciels dits "de routage" à partir d'un schéma d'interconnexion qui leur est fourni. Une fois le "routage" déterminé par le logiciel, on fait intervenir un sous-programme de mise en oeuvre de l'invention définissant de façon automatique un certain nombre d'interconnexions factices entre ces pistes. Ce nombre d'interconnexions factices est de préférence élevé, dans les limites permises par la technologie de fabrication. Par exemple, une interconnexion factice peut être systématiquement prévue à chaque croisement de deux pistes conductrices de deux niveaux de profondeur adjacents. Dans ce cas, la présente invention peut permettre de multiplier au moins par 10 le temps d'analyse par ingénierie inverse d'un circuit intégré comprenant un millier de portes logiques, actuellement de l'ordre de la centaine d'heures (opérations d'abrasion chimique non comprises). Ce résultat avantageux est dû au fait que l'analyse inverse d'un circuit intégré selon l'invention nécessite d'avoir recours à l'étape iii) du procédé décrit plus haut (observation des signaux au microscope électronique) pour découvrir les équipotentielles du circuit, la réalisation des étapes i) et ii) (reconstitution visuelle du schéma d'interconnexion) étant rendue impossible par la présente invention.

Par ailleurs, bien que l'on ait proposé dans ce qui précède de prévoir des orifices d'interconnexion factices dans les zones de pistes reliant les zones actives d'un circuit intégré, il est bien évident que le procédé de l'invention peut également être appliqué aux zones actives elles-mêmes lorsque celles-ci présentent des interconnexions avec des pistes enterrées.

Enfin, il apparaîtra clairement à l'homme de l'art que le champ d'application de la présente invention est très étendu et concerne de façon générale tous les circuits intégrés dont l'intégrité doit être préservée. Parmi ces circuits intégrés figurent notamment les circuits intégrés des cartes à puces ou équivalents qui possèdent des fonctions d'authentification à logique câblée dont les mécanismes doivent être protégés.

## Revendications

1. Procédé de fabrication d'un circuit intégré (10, 30), comprenant une étape de fabrication d'au moins un premier niveau de pistes conductrices (12-1, 12-2, 12-3, 21), une étape de fabrication d'une couche isolante (13, 22) couvrant le premier niveau de pistes conductrices, une étape de fabrication dans la couche isolante d'une pluralité d'orifices d'interconnexion (v1, v3, v4, v5, vi, vj) traversant entièrement la couche isolante, et une étape de fabrication d'au moins un deuxième niveau de pistes conductrices (14, 26) susceptibles d'être connectées électriquement aux pistes du premier niveau au moyen desdits orifices d'interconnexion, **caractérisé en ce qu'**il comprend, avant la fabrication du deuxième niveau de pistes conductrices, une étape de fabrication d'une barrière d'isolement électrique (16, 17, 25) pour l'isolement électrique d'au moins un orifice d'interconnexion, la barrière d'isolement étant d'une épaisseur très faible dans l'orifice d'interconnexion ou comprenant une jonction PN sous l'orifice d'interconnexion, de telle sorte que l'orifice est rempli par de la matière conductrice du deuxième niveau de pistes au moins sur une grande partie de sa hauteur.

2. Procédé selon la revendication 1, dans lequel l'étape de fabrication de la barrière d'isolement électrique comprend une étape de fabrication d'une couche (16, 25) d'un matériau isolant dans l'orifice d'interconnexion (v3, v4, vi)

3. Procédé selon la revendication 1, dans lequel l'étape de fabrication de la barrière d'isolement électrique comprend une étape de fabrication d'au moins une couche de silicium dopé dans l'orifice d'interconnexion.

4. Procédé selon la revendication 1, dans lequel l'étape de fabrication de la barrière d'isolement électrique comprend une étape de fabrication, dans une piste conductrice (12-3) en silicium dopé N ou P, d'une zone (17) de diffusion inverse P ou N formant avec la piste (12-3) une jonction PN, à l'endroit où débouche l'orifice d'interconnexion (v5).

5. Circuit intégré (10, 30) fabriqué selon le procédé de la revendication 1, comprenant des pistes conductrices (12-1, 12-2, 12-3, 14, 21, 26) réparties sur au moins un premier (N1) et un second niveau (N2) de profondeur du circuit intégré, et des orifices (v1, v3, v4, v5, vi, vj) d'interconnexion présumée de pistes des premier et second niveaux pratiqués dans toute l'épaisseur d'une couche isolante (13, 22) séparant les deux niveaux de pistes, certains orifices d'interconnexion présumée (v3, v4, v5, vi) comportant une barrière d'isolement électrique (16, 17, 25) et ne reliant pas électriquement des pistes (12-2, 14, 21, 26) des premier et second niveaux.

6. Circuit selon la revendication 5, comprenant des orifices (v3, v4, vi) comportant une couche d'oxyde (16, 25) formant la barrière d'isolement électrique.

7. Circuit selon la revendication 5, comprenant des orifices (v5) comportant une jonction silicium de type PN ou NP formant la barrière d'isolement électrique.

8. Circuit selon la revendication 5, comprenant des orifices (v5) débouchant sur une jonction silicium de type PN ou NP (12-3, 17) formant la barrière d'isolement électrique.

## Patentansprüche

1. Verfahren zur Herstellung eines integrierten Schaltkreises (10, 30), umfassend eine Stufe zur Herstellung von mindestens einer ersten Ebene von Leitungswegen (12-1, 12-2, 12-3, 21), eine Stufe zur Herstellung einer isolierenden Schicht (13, 22), die die erste Ebene von Leitungswegen bedeckt, eine Stufe zur in der isolierenden Schicht vorgesehenen Herstellung einer Vielzahl von Zwischenanschlussöffnungen (v1, v3, v4, v5, vi, vj), die die isolierende Schicht gänzlich überqueren, sowie eine Stufe zur Herstellung von mindestens einer zweiten Ebene von Leitungswegen (14, 26), die geeignet sind, elektrisch an die Wege der ersten Ebene mittels der genannten Zwischenanschlussöffnungen angeschlossen zu werden, **dadurch gekennzeichnet, dass** es, vor der Herstellung der zweiten Ebene von Leitungswegen, eine Stufe zur Herstellung einer elektrischen Isolierungsbarriere (16, 17, 25) zur elektrischen Isolierung von mindestens einer Zwischenanschlussöffnung umfasst, wobei die Isolierungsbarriere eine sehr geringe Dicke in der Zwischenanschlussöffnung oder in einem Verbindungsstück PN unter der Zwischenanschlussöffnung aufweist, und zwar so, dass die Öffnung mit der leitfähigen Materie der zweiten Wege-Ebene zumindest auf einem großen Teil ihrer Höhe ausgefüllt ist.

2. Verfahren gemäß Anspruch 1, worin die Stufe zur Herstellung der elektrischen Isolierungsbarriere eine Stufe zur Herstellung einer Schicht (16, 25) aus einem isolierenden Material in der Zwischenanschlussöffnung (v3, v4, vi) umfasst.

3. Verfahren gemäß Anspruch 1, worin die Stufe zur Herstellung der elektrischen Isolierungsbarriere eine Stufe zur Herstellung von mindestens einer Schicht aus dotiertem Silizium in der Zwischenanschlussöffnung umfasst.

4. Verfahren gemäß Anspruch 1, worin die Stufe zur Herstellung der elektrischen Isolierungsbarriere eine Stufe zur Herstellung, in einem Leitungsweg (12-3) aus mit N oder P dotiertem Silizium, einer Zone (17) zur inversen Diffusion von P oder N umfasst, wobei mit dem Weg (12-3) ein Verbindungsstück PN am Ort oder der Einmündung der Zwischenanschlussöffnung (v5) gebildet wird.

5. Integrierter Schaltkreis (10, 30), hergestellt mit dem Verfahren gemäß Anspruch 1, umfassend Leitungswege (12-1, 12-2, 12-3, 14, 21, 26), die auf mindestens einer ersten (N1) und einer zweiten Ebene (N2) der Tiefe des integrierten Schaltkreises verteilt sind, und Öffnungen (v1, v3, v4, v5, vi, vj) eines vorgesehenen Zwischenanschlusses aus Wegen der ersten und zweiten Ebenen, die in der ganzen Dicke einer isolierenden Schicht (13, 22) ausgeführt sind, die die zwei Ebenen der Wege trennt, wobei bestimmte Öffnungen des vorgesehenen Zwischenanschlusses (v3, v4, v5, vi) eine elektrische Isolierungsbarriere (16, 17, 25) aufweisen und elektrisch nicht mit den Wegen (12-2, 14, 21, 26) der ersten und zweiten Ebenen zusammenhängen.

6. Schaltkreis gemäß Anspruch 5, umfassend Öffnungen (v3, v4, vi), welche eine Oxidschicht (16, 25) aufweisen, die die elektrische Isolierungsbarriere bildet.

7. Schaltkreis gemäß Anspruch 5, umfassend Öffnungen (v5), die ein Silizium-Verbindungsstück vom PN- oder NP-Typ aufweisen, das die elektrische Isolierungsbarriere bildet.

8. Schaltkreis gemäß Anspruch 5, umfassend Öffnungen (v5), die auf einem Silizium-Verbindungsstück vom PN- oder NP-Typ (12-3, 17) münden, das die elektrische Isolierungsschicht bildet.

## Claims

1. A method of making an integrated circuit (10, 30) comprising a step of making at least one first level of conductor tracks (12-1, 12-2, 12-3, 21), a step of making an insulating layer (13, 22) covering the first level of conductor tracks, a step of making in the insulating layer a plurality of interconnection orifices (v1, v3, v4, v5, vi, vj) passing entirely through the insulating layer, and a step of making at least one second level of conductor tracks (14, 26) which are capable of being electrically connected to the tracks of the first level by means of said interconnection orifices, **characterised in that**, prior to the step of making the second level of conductor tracks, it comprises a step of making an electrical insulation barrier (16, 17, 25) for electrical insulation of at least one interconnection orifice, the insulation barrier being of a very small thickness in the interconnection orifice or a PN junction under the interconnection orifice in such a way that the orifice is filled by the conducting material of the second level of tracks at least over a large part of its height.

2. A method according to claim 1 wherein the step of making the electrical insulation barrier comprises a step of making a layer (16, 25) of an insulating material in the interconnection orifice (v3, v4, vi).

3. A method according to claim 1 wherein the step of making the electrical insulation barrier comprises a step of making at least one doped silicon layer in the interconnection orifice.

4. A method according to claim 1 wherein the step of making the electrical insulation barrier comprises a step of making, in a conductor track (12-3) of N or P doped silicon, a P or N reverse diffusion zone (17) forming with the track (12-13) a PN junction, at the location at which the interconnection orifice (v5) opens.

5. An integrated circuit (10, 30) made by the method according to claim 1 comprising conductor tracks (12-1, 12-2, 12-3, 14, 21, 26) distributed over at least a first level (N1) and a second level (N2) in respect of depth of the integrated circuit, and orifices (v1, v3, v4, v5, vi, vj) for presumed interconnection of tracks of the first and second levels provided in the entire thickness of an insulating layer (13, 22) separating the two levels of tracks, some presumed interconnection orifices (v3, v4, v5, vi) comprising an electrical insulation barrier (16, 17, 25) and not electrically connecting tracks (12-2, 14, 21, 26) of the first and second levels.

6. A circuit according to claim 5 comprising orifices (v3, v4, vi) comprising an oxide layer (16, 25) forming the electrical insulation barrier.

7. A circuit according to claim 5 comprising orifices (v5) comprising a PN or NP type silicon junction forming the electrical insulation barrier.

8. A circuit according to claim 5 comprising orifices (v5) opening to a PN or NP type silicon junction (12-3, 17) forming the electrical insulation barrier.
